# FASCICULE DE BREVET EUROPEEN

(11) **EP 0 904 599 B1**
(45) Date de publication et mention de la délivrance du brevet: **25.09.2002**
(21) Numéro de dépôt: 97928309.0
(22) Date de dépôt: 09.06.1997
(51) Int. Cl.: H01L 21/027, G03F 7/09, H01L 21/321

(54) **PROCEDE DE GRAVURE DE LA GRILLE EN TECHNOLOGIE MOS UTILISANT UN MASQUE DUR A BASE DE SiON**
VERFAHREN ZUM ÄTZEN DES GATES IN MOS TECHNOLOGIE UNTER VERWENDUNG EINER HARTEN MASKE AUF DER BASIS VON SiON
METHOD FOR ETCHING THE GATE IN MOS TECHNOLOGY USING A SiON BASED HARD MASK

(30) Priorité: 13.06.1996 FR 9607346
(43) Date de publication de la demande: 31.03.1999
(73) Titulaire: FRANCE TELECOM, 75015 Paris (FR)
(72) Inventeur: SCHIAVONE, Patrick, F-38190 Villard-Bonnot (FR); GAILLARD, Frédéric, F-38500 Voiron (FR)
(74) Mandataire: Casalonga, Axel
(86) Numéro de dépôt international: FR9701015
(87) Numéro de publication internationale: WO97048127

(56) Documents cités:
- EP-A- 0 588 087
- US-A- 5 066 615
- US-A- 5 378 659
- PATENT ABSTRACTS OF JAPAN vol. 018, no. 684 (E-1650), 22 Décembre 1994 & JP 06 275574 A (SONY CORP), 30 Septembre 1994,
- PATENT ABSTRACTS OF JAPAN vol. 95, no. 003 & JP 07 066176 A (SONY CORP), 10 Mars 1995,
- PATENT ABSTRACTS OF JAPAN vol. 95, no. 006 & JP 07 161689 A (SONY CORP), 23 Juin 1995,
- PATENT ABSTRACTS OF JAPAN vol. 95, no. 004 & JP 07 106308 A (SONY CORP), 21 Avril 1995,
- INTERNATIONAL CONFERENCE ON SOLID STATE DEVICES AND MATERIALS, 29 Août 1993, pages 570-572, XP000409442 TETSUO GOCHO ET AL: "CVD METHOD OF ANTI-REFLECTIVE LAYER FILM FOR EXCIMER LASER LITHOGRAPHY"
- IEEE TRANSACTIONS ON ELECTRON DEVICES, vol. 40, no. 6, 1 Juin 1993, pages 1161-1165, XP000368256 ZHIZHANG CHEN: "A NOVEL AND EFFECTIVE PECVD SIO2/SIN ANTIREFLECTION COATING FOR SI SOLAR CELLS"
- PATENT ABSTRACTS OF JAPAN vol. 011, no. 359 (E-559), 21 Novembre 1987 & JP 62 136022 A (SEIKO EPSON CORP), 19 Juin 1987,
- PATENT ABSTRACTS OF JAPAN vol. 013, no. 246 (E-769) 08 Juin 1989 & JP 01 047 073 A (YOKOGAWA ELECTRIC CORP) 21 Février 1989

## Description

L'invention concerne la gravure du matériau de grille dans la fabrication de transistors à effet de champ.

Dans la fabrication des transistors MOS, on utilise généralement du polysilicium ou un alliage de silicium et de germanium comme matériau de grille. Ce matériau est déposé sur une couche mince d'oxyde thermique, encore appelé oxyde de grille, puis gravé aux dimensions de la grille.

La gravure, par quelque moyen que ce soit, peut s'effectuer en utilisant un masque dur définissant la zone destinée à former ultérieurement la grille et protégeant ladite zone pendant l'opération. On utilise alors habituellement pour le masque dur un matériau inorganique, tel que ie dioxyde de silicium ou le nitrure de silicium. L'absence de carbone dans le matériau constituant le masque, responsable de la destruction de la couche d'oxyde de grille lors de la gravure de la grille, permet d'augmenter de manière significative la sélectivité de la gravure du matériau de grille en silicium polycristallin ou en un alliage silicium-germanium par rapport à l'oxyde de grille.

Néanmoins, l'utilisation de ces masques classiques présente des inconvénients qui nuisent à la qualité des transistors fabriqués.

Il est connu d'isoler les futures zones actives d'un dispositif semi-conducteur de façon conventionnelle (LOCOS) ou par tranchées peu profondes (Shallow Trench Isolation : STI) avec du dioxyde de silicium. Lorsque le masque dur de la gravure de la grille est en dioxyde de silicium, son retrait engendre un risque d'évidement des tranchées ou de destruction de la zone d'isolement puisqu'il est de même nature que l'oxyde d'isolement.

Par ailleurs, l'utilisation d'un masque dur à base de nitrure de silicium présente des risques de destruction du matériau de grille lors du retrait du masque. En effet, le procédé de gravure du nitrure de silicium est très voisin de celui du silicium, ce qui induit une faible sélectivité de gravure entre ces 2 matériaux et une détection de fin d'attaque du masque dur s'effectuant sur la grille ne saurait suffire à éviter une destruction, partielle, de la grille sous-jacente au masque dur.

Il apparaît donc nécessaire de mettre au point un procédé de gravure du matériau de grille qui ne présente pas les inconvénients énumérés ci-dessus.

Les inventeurs ont mis en évidence que l'utilisation d'une couche mince et poreuse à base d'oxyde de silicium nitruré SiON, comme masque dur pour la gravure du matériau de grille, permet de surmonter les inconvénients observés avec les masques de l'art antérieur. Le matériau SiON possède toutes les propriétés requises d'un masque dur. Son retrait est en outre simplifié sans aucune destruction ni de l'oxyde thermique, ni du matériau de grille.

Un tel masque de SiON est utilisé dans le procédé décrit dans le document JP-A-6 275 574. Un masque de nitrure de silicium sur une couche d'oxyde de silicium est connu du document JP-A- 1 047 073.

Dans le domaine de la microélectronique, l'oxyde de silicium nitruré est généralement utilisé comme matériau de couches antiréflectives. Ce matériau limite notamment la réflectivité de couches sous-jacentes à base de tungstène ou d'aluminium lors de la photolithographie de ces couches, ainsi que les effets de réflexion parasites sur les couches sous-jacentes lors de l'insolation de la couche organique photosensible.

L'invention propose un procédé de gravure du matériau de grille dans la fabrication de transistors à effet de champ, comprenant au moins les étapes suivantes:
a) on dépose une couche mince et poreuse d'un alliage à base de SiON sur un substrat semi-conducteur recouvert d'une première couche d'oxyde thermique et d'une deuxième couche en silicium polycristallin ou en un alliage silicium-germanium;
b) à l'aide d'un masque en résine réalisé sur la couche à base de SiON, on grave ladite couche pour former un masque dur;
c) après retrait de la résine masquante, on grave la zone prédéterminée par le masque dur dans la couche en silicium polycristallin ou en un alliage silicium-germanium pour former la future grille; et
d) on retire le masque dur à base de SiON.

Selon l'invention, dans l'étape a), on entend par couche mince une couche dont l'épaisseur est comprise entre 50 et 200 nm, typiquement 150 nm. La composition de l'alliage constituant cette couche est SiₓO_{y}N_{z} dans laquelle x est compris entre 35 et 45% et z compris entre 40 et 60%, y formant le complément jusqu'à 100%. Ces pourcentages sont des pourcentages atomiques.

Selon une mise en oeuvre préférentielle de l'invention, la couche d'alliage à base de SiON peut être déposée sur le matériau de grille chimiquement en phase vapeur assisté par plasma à faible température, plus particulièrement de l'ordre de 300°C.

Selon une mise en oeuvre du procédé de l'invention, la gravure du masque dur à base de SiON dans l'étape b) est avantageusement assistée d'une détection de fin d'attaque s'effectuant sur la couche sous-jacente à base de silicium polycristallin ou d'un alliage silicium-germanium agissant alors en tant que couche d'arrêt de l'opération.

Selon le procédé de l'invention, dans l'étape c), la gravure de la grille dans la couche à base de silicium polycristallin ou d'un alliage silicium-germanium, peut également être avantageusement assistée d'une détection de fin d'attaque s'effectuant sur la couche d'oxyde thermique agissant en tant que couche d'arrêt de l'opération.

Dans l'étape d), le masque dur à base de SiON peut être retiré par voie chimique, tel que notamment par gravure liquide, ou gravure par plasma. Cette opération peut avantageusement être assistée d'une détection de fin d'attaque s'effectuant sur la future grille agissant alors en tant que couche d'arrêt de l'opération.

Selon un autre mode de réalisation de l'invention, dans l'étape d), le retrait du masque dur à base de SiON est précédé d'une étape de formation d'espaceurs latéraux à base de dioxyde de silicium ou de nitrure de silicium disposés de chaque côté de la future grille.

D'autres avantages et caractéristiques de l'invention apparaîtront à l'examen de la description détaillée des modes de mise en oeuvre et de réalisation de l'invention, nullement limitatifs, et des dessins annexés, sur lesquels:

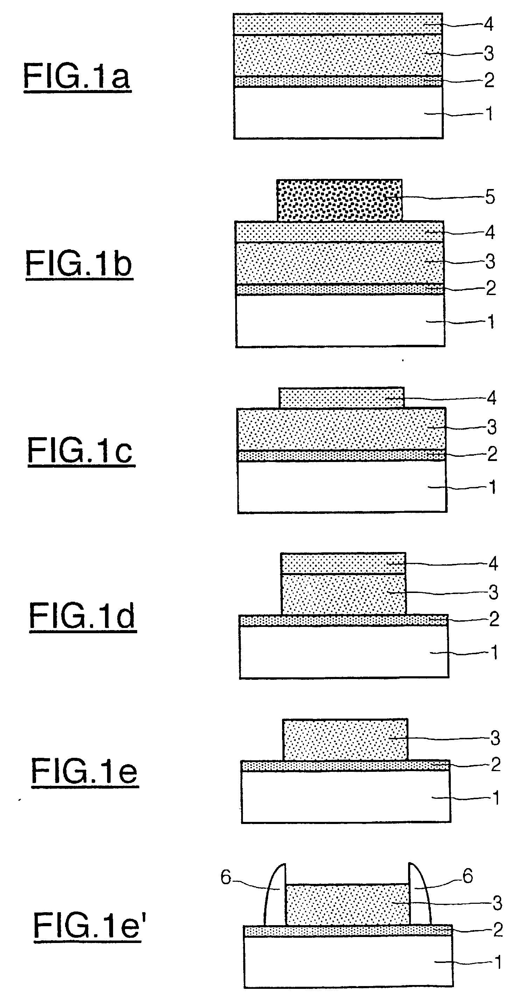

les figures 1a à 1e et 1é illustrent la mise en oeuvre du procédé de l'invention.

Tel qu'illustré à la figure 1a, sur un substrat semi-conducteur 1 recouvert successivement d'une couche d'oxyde thermique 2 et d'une couche d'un matériau de grille, on dépose une couche mince et poreuse 4 d'un alliage à base de SiON. La couche d'oxyde thermique 2 est généralement constituée de dioxyde de silicium et a typiquement une épaisseur comprise entre 3 et 25 nm. Le matériau de grille est à base de de silicium polycristallin ou d'un alliage de silicium-germanium et présente une épaisseur comprise entre 100 et 400 nm, typiquement 200 nm.

Selon une mise en oeuvre préférentielle de l'invention, la couche à base de SiON est déposée chimiquement en phase vapeur assistée par plasma (PECVD) à faible température. On emploiera typiquement des températures de l'ordre de 300°C. Ce type de dépôt présente l'avantage par rapport au dépôt par four à haute température, de n'utiliser qu'un faible bilan thermique. Lors des dépôts à haute température par four, on observe une diffusion des dopants lorsqu'on dépose sur des matériaux déjà dopés. Avec le dépôt PECVD à faible température selon l'invention, on réduit, voire supprime, la diffusion des dopants à l'intérieur des matériaux.

Les autres conditions de mise en oeuvre du procédé de dépôt PECVD sont usuelles pour le domaine de la microélectronique. On opère préférentiellement sous gaz inerte, par exemple azote, argon ou hélium, de façon usuelle. Le mélange gazeux actif contient des précurseurs des éléments constitutifs de l'alliage à base de SiON. La composition de l'alliage est SiₓO_{y}N_{z}, dans laquelle x est compris entre 35 et 45%, z est compris entre 40 et 60% et y forme le complément jusqu'à 100%. Ces pourcentages sont des pourcentages atomiques.

En variant le mélange gazeux lors du dépôt, on peut modifier la composition de la couche à base de SiON.

En agissant sur la proportion d'azote compris dans l'alliage et sur les conditions de température lors du dépôt, on peut faire varier la sélectivité, notamment lors du retrait du masque, par rapport au dioxyde de silicium en utilisant un fort pourcentage atomique d'azote ou par rapport au nitrure de silicium en diminuant la proportion d'azote. Il est ainsi possible, en agissant sur le mélange gazeux, d'optimiser la sélectivité de la gravure du masque par rapport aux autres matériaux présents et découverts.

On dépose ainsi une couche mince et poreuse à base de SiON, d'épaisseur comprise entre 50 et 200 nm, typiquement 150 nm, référencée 4 sur la figure 1a, sur la couche 3 de matériau de grille.

Tel qu'illustré à la figure 1b, une résine masquante photosensible a été déposée sur la couche mince et poreuse 4 à base de SiON, et gravée, par exemple par photolithogravure à l'aide d'un masque reproduisant la zone destinée à former ultérieurement la grille. A l'aide de ce masque en résine 5, on grave la couche mince et poreuse 4 à base de SiON par gravure anisotrope sèche pour former le masque dur également référencé 4.

Cette étape de gravure du masque dur est avantageusement assistée par une détection de fin d'attaque s'effectuant sur la couche 3 en silicium polycristallin ou en un alliage silicium-germanium, agissant alors en tant que couche d'arrêt. La gravure et la détection de fin d'attaque s'effectuent dans des conditions usuelles pour le domaine de la microélectronique.

Après gravure du masque dur 4, on retire, de façon usuelle, la résine masquante. On obtient le dispositif illustré à la figure 1c, sur laquelle le substrat semi-conducteur 1 est recouvert d'une première couche 2 d'oxyde thermique et d'une deuxième couche 3 à base de silicium polycristallin ou d'un alliage en silicium-germanium. Cette dernière couche est surmontée d'un masque dur 4 à base d'un alliage SiON prédéterminant la zone destinée à former la grille.

Tel qu'illustré à la figure 1d, la couche 3 est gravée de manière conventionnelle par gravure anisotrope sèche en utilisant le masque dur 4 à base de SiON, pour former la future grille du transistor MOS. La gravure du matériau de grille peut avantageusement être assistée d'une détection de fin d'attaque s'effectuant sur la couche 2 d'oxyde thermique agissant alors en tant que couche d'arrêt de l'opération de gravure.

Le procédé de l'invention présente un avantage supplémentaire dans cette étape de gravure de la grille, dans la mesure où le matériau SiON utilisé comme masque dur possède des propriétés antiréflectives limitant la réflection sur la couche sous-jacente lorsque celle-ci est gravée par photolithogravure.

Dans une dernière étape, le masque dur 4 à base de SiON est retiré de manière simplifiée. Ce retrait s'effectue préférentiellement par voie chimique, notamment par gravure isotrope liquide, ou par plasma. Il s'avère en effet que le retrait par voie chimique ne détruit pas la couche d'oxyde thermique 2 apparente puisque la vitesse de gravure du matériau à base de SiON peut atteindre cent cinquante fois celle du dioxyde de silicium et sept fois celle du nitrure de silicium en gravure liquide et quarante fois celle du dioxyde de silicium en gravure plasma. En outre, la sélectivité de cette opération de retrait est infinie par rapport au silicium polycristallin et à l'alliage silicium-germanium constituant le matériau de grille. Cette différence infinie entre les vitesses d'attaque du matériau à base de SiON et du matériau de grille, permet avantageusement d'assister l'étape de retrait du masque dur 4 d'une détection de fin d'attaque s'effectuant sur la couche 3 formant la grille et agissant alors en tant que couche d'arrêt de la gravure. Les conditions de gravure et de détection de fin d'attaque sont usuelles dans le domaine de la microélectronique.

L'importante sélectivité lors du retrait du masque de l'attaque du matériau à base de SiON par rapport aux matériaux qui l'entourent, peut également avantageusement être utilisée lors du retrait du masque dur après formation d'espaceurs latéraux à base de dioxyde de silicium ou de nitrure de silicium. Ainsi, selon un mode de réalisation de l'invention, l'étape de retrait du masque dur à base de SiON est précédée d'une étape de formation d'espaceurs latéraux 6 à base de dioxyde de silicium ou de nitrure de silicium disposés de chaque côté de la future grille 3. Il est ainsi possible d'obtenir, après retrait du masque dur, des espaceurs 6 dont la hauteur est supérieure, d'environ la valeur de l'épaisseur de la couche de SiON, à la hauteur de grille. Ce type d'espaceurs est intéressant, notamment pour limiter les phénomènes de courts-circuits observés entre la grille et la zone active lors de la siliciuration sélective du silicium.

Ainsi, selon le mode de réalisation de l'invention mis en oeuvre, on obtient les dispositifs illustrés aux figures 1e et 1e'.

Sur la figure 1e, le substrat semi-conducteur 1 est recouvert sur toute sa surface d'un oxyde thermique 2 sur lequel la couche 3 à base de silicium polycristallin ou d'un alliage silicium-germanium forme la future grille d'un transistor MOS.

Sur la figure 1e', le substrat semi-conducteur 1 est recouvert sur toute sa surface d'un oxyde thermique 2, sur lequel des espaceurs 6 en dioxyde de silicium ou nitrure de silicium sont disposés de part et d'autre de la future grille 3 à base de silicium polycristallin ou d'un alliage silicium-germanium. Ces espaceurs présentent une hauteur supérieure d'environ l'épaisseur du masque dur à base de SiON, par rapport à la hauteur de grille.

Le dispositif semi-conducteur ainsi obtenu peut subir les traitements ultérieurs habituels nécessaires à la fabrication d'un transistor MOS.

## Revendications

1. Procédé de gravure du matériau de grille dans la fabrication de transistors MOS, comprenant au moins les étapes suivantes:
a) on dépose une couche mince et poreuse (4) d'un alliage à base de SiON (4) de composition est SiₓO_{y}N_{z} avec x compris entre 35 et 45% atomique, z compris entre 40 et 60% atornique, y différent de zéro complétant jusqu'à 100% atomique, sur un substrat semi-conducteur (1) déjà recouvert d'une première couche (2) d'oxyde thermique et d'une deuxième couche (3) en silicium polycristallin ou en un alliage silicium-germanium;
b) à l'aide d'un masque en résine (5) réalisé sur la couche mince et poreuse (4) à base de SiON, on grave ladite couche mince et poreuse (4) pour former un masque dur;
c) après retrait de la résine masquante (5), on grave la zone prédéterminée par le masque dur (4) dans la deuxième couche (3) à base de silicium polycristallin ou d'un alliage silicium-germanium pour former la future grille; et
d) on retire le masque dur (4) à base d'un alliage SiON.

2. Procédé selon la revendication 1, **caractérisé en ce que** dans l'étape a), la couche mince et poreuse (4) d'alliage à base de S₁ON a une épaisseur comprise entre 50 et 200 nm, typiquement 150 nm.

3. Procédé selon la revendication 1 ou 2, **caractérisé en ce que** la couche mince et poreuse (4) à base de SiON est déposée chimiquement en phase vapeur assistée par plasma à faible température.

4. Procédé selon l'une quelconque des revendications 1 à 3, **caractérisé en ce que** dans l'étape b), la gravure du masque dur est assistée d'une détection de fin d'attaque s'effectuant sur la deuxième couche (3) à base de silicium polycristallin ou d'un alliage silicium-germanium. agissant alors en tant que couche d'arrêt.

5. Procédé selon l'une quelconque des revendications 1 à 4, **caractérisé en ce que** dans l'étape c), la gravure de la grille dans la deuxième couche (3) est assistée d'une détection de fin d'attaque s'effectuant sur la couche d'oxyde thermique (2) agissant en tant que couche d'arrêt.

6. Procédé selon l'une quelconque des revendications 1 à 5, **caractérisé en ce que** le masque dur (4) à base de S₁ON est retiré par gravure isotropique liquide dans l'étape d).

7. Procédé selon l'une quelconque des revendications 1 à 5, **caractérisé en ce que** le masque dur (4) à base de SiON est retiré par gravure par plasma dans l'étape d).

8. Procédé selon la revendication 6 ou 7, **caractérisé en ce que** la gravure est assistée d'une détection de fin d'attaque s'effectuant sur la deuxième couche (3) à base de silicium polycristallin ou d'un alliage silicium-germanium, agissant en tant que couche d'arrêt.

9. Procédé selon l'une quelconque des revendications 1 à 8, **caractérisé en ce que** dans l'étape d), le retrait du masque dur (4) à base de SiON est précédé d'une étape de formation d'espaceurs latéraux (6) à base de dioxyde de silicium ou de nitrure de silicium disposés de chaque côté de la future grille (3).

## Claims

1. Process for etching the gate material in the fabrication of MOS transistors, comprising at least the following steps:
a) a thin and porous layer of an SiON-based alloy (4) whose composition is SiₓO_{y}N_{z}, in which x is between 35 and 45 at% and z is between 40 and 60 at%, y differing from zero and making the total up to 100 at%, is deposited on a semiconductor substrate (1) already coated with a thermal oxide first layer (2) and with a second layer (3) made of polycrystalline silicon or of a silicon-germanium alloy;
b) the said thin and porous layer (4) is etched, using a resin mask (5) produced on the SiON-based thin and porous layer (4), in order to form a hard mask;
c) after the masking resin (5) has been removed, the region predefined by the hard mask (4) in the second layer (3) based on polycrystalline silicon or on a silicon-germanium alloy is etched in order to form the future gate; and
d) the hard mask (4) based on an SiON alloy is removed.

2. Process according to Claim 1, **characterized in that**, in step a), the thin and porous layer (4) of an SiON-based alloy has a thickness of between 50 and 200 nm, typically 150 nm.

3. Process according to Claim 1 or 2, **characterized in that** the thin and porous SiON-based layer (4) is deposited by low-temperature plasma-enhanced chemical vapour deposition.

4. Process according to any one of Claims 1 to 3, **characterized in that**, in step b), the etching of the hard mask is assisted by end-of-etching detection that takes place at the second layer (3) based on polycrystalline silicon or on a silicon-germanium alloy then acting as stop layer.

5. Process according to any one of Claims 1 to 4, **characterized in that**, in step c), the etching of the gate in the second layer (3) is assisted by end-of-etching detection that takes place at the thermal oxide layer (2) acting as stop layer.

6. Process according to any one of Claims 1 to 5, **characterized in that** the SiON-based hard mask (4) is removed by liquid isotropic etching in step d).

7. Process according to any one of Claims 1 to 5, **characterized in that** the SiON-based hard mask (4) is removed by plasma etching in step d).

8. Process according to Claim 6 or 7, **characterized in that** the etching is assisted by end-of-etching detection that takes place at the second layer (3) based on polycrystalline silicon or on a silicon-germanium alloy acting as stop layer.

9. Process according to any one of Claims 1 to 8, **characterized in that**, in step d), the removal of the SiON-based hard mask (4) is preceded by a step of forming lateral spacers (6) based on silicon dioxide or on silicon nitride which are placed on each side of the future gate (3).

## Patentansprüche

1. Verfahren zum Ätzen des Gate-Materials bei der Herstellung vom MOS-Transistoren, welches wenigstens die folgenden Schritte umfasst:
a) Abscheiden einer dünnen und porösen Schicht (4) einer Legierung auf der Basis von SiON (4) mit der Zusammensetzung SiₓO_{y}N_{z}, wobei x zwischen 35 und 45 Atom-% liegt, z zwischen 40 und 60 Atom-% liegt, y von Null verschieden ist und auf 100 Atom-% ergänzt, auf ein Halbleitersubstrat (1), welches bereits von einer ersten thermischen Oxidschicht (2) und einer zweiten Schicht (3) aus polykristallinem Silizium oder aus einer Silizium-Germanium-Legierung bedeckt ist;
b) mithilfe einer Harzmaske (5), welche auf der dünnen und porösen Schicht (4) auf der Basis von SiON hergestellt wird, Gravieren der dünnen und porösen Schicht (4), um eine harte Maske zu formen;
c) nach Schrumpfen des maskierenden Harzes (5), Gravieren der durch die harte Maske (4) vorbestimmten Zone in der zweiten Schicht (3) auf der Basis von polykristallinem Silizium oder einer Silizium-Germanium-Legierung um das zukünftige Gate zu formen; und
d) Schrumpfen der harten Maske (4) auf der Grundlage einer SiON-Legierung.

2. Verfahren nach Anspruch 1, **dadurch gekennzeichnet, dass** in dem Schritt a) die dünne und poröse Schicht (4) einer Legierung auf der Basis von SiON eine Dicke hat, die zwischen 50 und 200 nm liegt und typisch 150 nm beträgt.

3. Verfahren nach Anspruch 1 oder 2, **dadurch gekennzeichnet, dass** die dünne und poröse Schicht (4) auf der Basis von SiON in der Dampfphase, unterstützt von Plasma mit geringer Temperatur, chemisch abgeschieden wird.

4. Verfahren nach einem der Ansprüche 1 bis 3, **dadurch gekennzeichnet, dass** in dem Schritt b) das Ätzen der harten Maske von einer Erfassung des Endes des auf der zweiten Schicht (3) auf der Basis von polykristallinem Silizium oder einer Silizium-Germanium-Legierung erfolgenden Angriffs unterstützt wird, welche somit wie eine Sperrschicht wirkt.

5. Verfahren nach einem der Ansprüche 1 bis 4, **dadurch gekennzeichnet, dass** in dem Schritt c) das Ätzen des Gate in der zweiten Schicht (3) von einer Erfassung des Endes des auf der thermischen Oxidschicht (2) erfolgenden Angriffs unterstützt wird, welche somit wie eine Sperrschicht wirkt.

6. Verfahren nach einem der Ansprüche 1 bis 5, **dadurch gekennzeichnet, dass** die harte Maske (4) auf der Basis von SiON in dem Schritt d) durch isotropes Flüssigätzen geschrumpft wird.

7. Verfahren nach einem der Ansprüche 1 bis 5, **dadurch gekennzeichnet, dass** die harte Maske (4) auf der Basis von SiON in dem Schritt d) durch Plasmaätzen geschrumpft wird.

8. Verfahren nach Anspruch 6 oder 7, **dadurch gekennzeichnet, dass** das Ätzen von einer Erfassung des Endes des auf der zweiten Schicht (3) auf der Basis von polykristallinem Silizium oder einer Silizium-Germanium-Legierung erfolgenden Angriffs unterstützt wird, welche somit wie eine Sperrschicht wirkt.

9. Verfahren nach einem der Ansprüche 1 bis 8, **dadurch gekennzeichnet, dass** in dem Schritt d) dem Schrumpfen der harten Maske (4) auf der Basis von SiON ein Schritt zur Bildung von seitlichen Abstandshaltern (5) auf der Basis von Siliziumdioxid oder Siliziumnitrid, welche auf jeder Seite des zukünftigen Gate (3) angeordnet sind, vorausgeht.
